(19) Europäisches Patentamt / European Patent Office / Office européen des brevets

(11) **EP 2 362 415 A1**

(12) **EUROPEAN PATENT APPLICATION**
published in accordance with Art. 153(4) EPC

(43) Date of publication:
**31.08.2011 Bulletin 2011/35**

(51) Int Cl.:
*H01L 21/683* (2006.01)    *H02N 13/00* (2006.01)
*B23Q 3/15* (2006.01)

(21) Application number: **09811420.0**

(22) Date of filing: **26.08.2009**

(86) International application number:
**PCT/JP2009/064831**

(87) International publication number:
**WO 2010/026893 (11.03.2010 Gazette 2010/10)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **04.09.2008 JP 2008226664**

(71) Applicant: **Creative Technology Corporation Tokyo 102-0083 (JP)**

(72) Inventor: **FUJISAWA Hiroshi**
**Nara-shi**
**Nara 630-8301 (JP)**

(74) Representative: **Vossius & Partner**
**Siebertstrasse 4**
**81675 München (DE)**

(54) **ELECTROSTATIC CHUCK DEVICE AND METHOD FOR DETERMINING ADSORBED STATE OF WAFER**

(57)    Provided is an electrostatic chuck device including attraction determining means, which enables a quick and accurate recognition of an attracted state of a substrate, and also provided is a method of determining an attracted state of a substrate, which enables a quick and accurate recognition of the attracted state of the substrate in the electrostatic chuck device. The electrostatic chuck device includes: an electrostatic chuck for attracting the substrate, the electrostatic chuck being provided on an upper surface side of a metal base; and attraction determining means for determining the attracted state of the substrate. Further, the method of determining an attracted state of a substrate is used for the electrostatic chuck device including the electrostatic chuck for attracting the substrate, the electrostatic chuck being provided on the upper surface side of the metal base, the method including obtaining, by a heat flux sensor, a flow of heat transferred from the substrate via the electrostatic chuck, to thereby determine the attracted state of the substrate.

FIG.4

EP 2 362 415 A1

**Description**

Technical Field

The present invention relates to an electrostatic chuck device and a method of determining an attracted state of a substrate, and more particularly, to an electrostatic chuck device, which includes attraction determining means for determining an attracted state of a substrate, and a method of determining an attracted state of a substrate, which employs the electrostatic chuck device.

Background Art

In a semiconductor manufacturing process, an electrostatic chuck device is used for attracting and holding a semiconductor substrate in various apparatuses such as an ion implantation apparatus, an ion doping apparatus, a plasma immersion apparatus, a lithographic apparatus using, for example, an electron beam or extreme ultraviolet (EUV) lithography, and a wafer inspection apparatus for silicon wafers or the like. In addition, in the field of liquid crystal manufacturing, the electrostatic chuck device is used for attracting and holding an insulating substrate in a substrate laminating apparatus, which is used for injecting liquid crystal between glass substrates, or in an ion doping apparatus.
The electrostatic chuck device is generally formed by stacking, on an upper surface side of a metal base, an electrostatic chuck for attracting a semiconductor substrate, a glass substrate, or the like. Then, when a predetermined voltage is applied to an attraction electrode included in the electrostatic chuck, an electric charge and an electric field are formed on a surface of the electrostatic chuck, thereby attracting such substrates with electrical force. When such an electrostatic chuck device is used in processing a substrate, the temperature of the substrate increases due to plasma processing, ion implantation, and the like. For example, in a case in which a silicon wafer is subjected to etching by a plasma apparatus, the temperature of the substrate reaches to approximately 200°C. In many cases, the substrate is partially masked by using a resist or the like at the time of the ion implantation or the plasma processing. However, if the resist becomes such a high-temperature state, the resist hardens more than necessary, which causes a problem in a subsequent removal process.
To address this, in the metal base, a liquid conduit for circulating a liquid coolant such as pure water is formed, thereby keeping the substrate at an appropriate temperature. However, there is a case in which a part of the substrate is not properly attracted because foreign matter, such as particles, is trapped when the electrostatic chuck is caused to hold the substrate, or because the substrate is not completely planarized in the first place. Moreover, there is a case in which the substrate fails to be attracted because of, for example, partial disconnection of the attraction electrode included in the electrostatic chuck or partial damage of an insulating layer covering the attraction electrode. In particular, in recent years, the upsizing of the semiconductor substrate and the glass substrate has made complete planarization of the substrate even more difficult, and has also required further improvement in attraction force of the electrostatic chuck device for attracting such substrates. For those reasons, the pattern of the attraction electrode is becoming more complicated, and the insulating layer is becoming thinner, resulting in an increased risk of such problems as described above. In a portion where the substrate is not properly attracted, the above-mentioned cooling effect does not function sufficiently, and hence the temperature of the substrate increases abnormally, causing a problem of a hardened resist. In addition, there is a fear that elements and the like formed on the substrate are affected.
In such circumstances, it is very important to recognize the attracted state of the substrate quickly and accurately in the electrostatic chuck device, and various studies thereon have been conducted so far. For example, there is proposed a method of determining an attracted state of a substrate based on a change in capacitance, which utilizes the fact that an electric line of force, which is generated by voltage application to the attraction electrode of the electrostatic chuck, reaches the substrate held by the electrostatic chuck (for example, see Patent Literature 1 and Patent Literature 2). Specifically, because the existence of a substrate, which has a higher dielectric constant than a vacuum, causes the capacitance to increase, a difference in capacitance occurs depending on whether or not the substrate exists, and this difference is detected to determine the attracted state of the substrate. Further, there is proposed a method of determining an attracted state of a substrate, in which a through-hole extending from a lower surface side of the metal base to a back surface of the substrate attracted onto the electrostatic chuck is provided, and the temperature of the substrate is directly measured with a thermometer (thermocouple or radiation thermometer) disposed within the through-hole (for example, see Patent Literature 3 and Patent Literature 4). This method relates to a technology in which a temperature profile of the substrate is created according to a contact state between the substrate and the electrostatic chuck, to thereby determine the attracted state based on an actually-measured temperature of the substrate and the temperature profile.
However, in the determination method performed based on the change in capacitance, a difference in capacitance is small between a state in which the substrate is attracted to the electrostatic chuck and a state in which the substrate is lifted up with no attraction force, and hence it is difficult to accurately determine an attached/detached state of the substrate. If a false determination is made regarding the attached/detached state of the substrate, for example, there arises a fear that the substrate fails to be released when a lifting pin is pushed upward from the lower surface side of the metal base to lift the substrate, or that excessive force is exerted on the substrate to cause a damage. On the other hand, in the determination method performed based on the temperature profile of the substrate, while the temperature of the substrate is measured when the substrate is processed using the electrostatic chuck device, the attracted state of the substrate is determined based on the temperature profile obtained in advance, and hence it is necessary to monitor a predetermined temperature change for the determination. For this reason, it takes some time for the determination. Further, the attracted state of the substrate is determined retroactively when the device is actually used, and hence, for example, in determining whether or not the substrate has failed to be attracted by using this method, considerable damage is already inflicted on the substrate when an abnormality is detected.

Inaddition, inboththedeterminationmethods described above, it is necessary to externally connect certain attraction determining means to the electrostatic chuck device (in the former determination method, at least capacitance measuring instrument and a determination circuit are necessary, whereas in the latter determination method, at least a radiation thermometer and a determination circuit are necessary), and hence large-scale equipment is required to determine the attracted state of the substrate.

Citation List

Patent Literature

Patent Literature 1: JP 07-7074 A
Patent Literature 2: JP 2000-228440 A
Patent Literature 3: JP 10-150099 A
Patent Literature 4: JP 2004-47512 A

Summary of Invention

Technical Problem

In view of the above, the inventor of the present invention and others have conducted intensive studies on the method of determining an attracted state of a substrate which is used in the electrostatic chuck device. As a result, it has been found that, by obtaining a heat flux from the substrate when the electrostatic chuck device is in use, that is, when the substrate side has higher temperature than the metal base, it is possible to determine the attracted state of the substrate quickly and accurately while overcoming the above-mentioned problems, which eventually lead to the completion of the present invention.

Therefore, an object of the present invention is to provide an electrostatic chuck device including attraction determining means, which enables quick and accurate recognition of an attracted state of a substrate in the electrostatic chuck device.

Further, another object of the present invention is to provide a method of determining an attracted state of a substrate, which enables quick and accurate recognition of an attracted state of a substrate in the electrostatic chuck device.

Solution to Problem

Specifically, the present invention provides an electrostatic chuck device including: an electrostatic chuck for attracting a substrate, the electrostatic chuck being provided on an upper surface side of a metal base; and attraction determining means for determining an attracted state of the substrate.

Further, the present invention provides a method of determining an attracted state of a substrate, which is used for an electrostatic chuck device including an electrostatic chuck for attracting the substrate, the electrostatic chuck being provided on an upper surface side of a metal base, the method including obtaining, by a heat flux sensor, a flow of heat transferred from the substrate via the electrostatic chuck, to thereby determine the attracted state of the substrate.

The electrostatic chuck device of the present invention includes the attraction determining means for determining the attracted state of the substrate that is attracted to the electrostatic chuck. According to a preferred mode of the present invention, it is desired that a heat flux sensor be used as the attraction determining means. Similarly to physical energy in general, heat flows from a higher-temperature side to a lower-temperature side, and thermal energy passing through a unit area can be understood as a heat flux (in $W/m^2$). The inventor of the present invention and others focused on the fact that, when the substrate is processed using the electrostatic chuck device, a temperature gradient is formed with the substrate having higher temperature than the metal base side, and have configured the present invention such that the attracted state of the substrate is determined by obtaining a flow of heat (heat flux) from the substrate on the lower-temperature side.

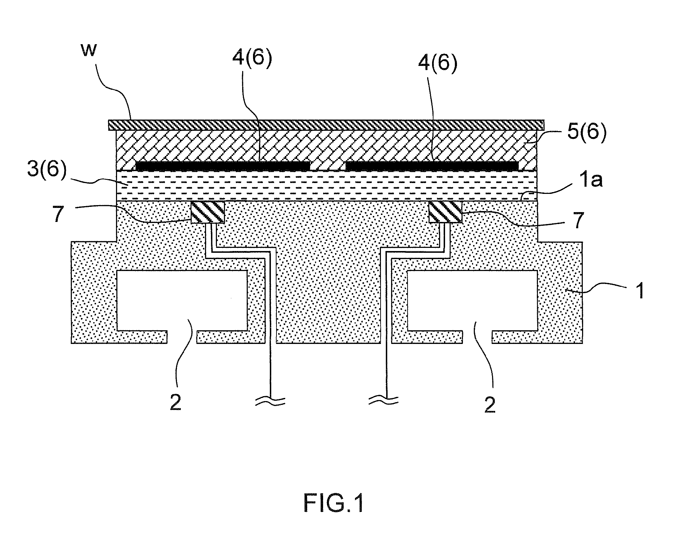

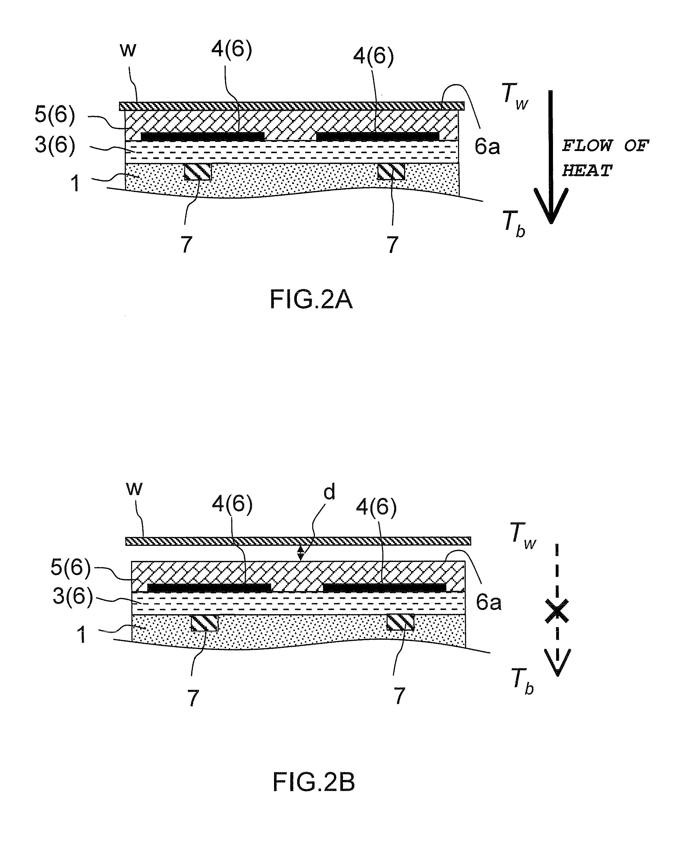

Part of this configuration is described with reference to FIG. 1 and FIGS. 2. When voltage is applied to attraction electrodes 4 included in an electrostatic chuck 6 to attract a substrate w onto a substrate attracting surface 6a of the electrostatic chuck 6, and the substrate w is processed by, for example, an ion implantation apparatus (not shown), the implanted ions or the like decelerate and release kinetic energy in the substrate, which accordingly causes the temperature of the substrate w to rise. On this occasion, in a metal base 1, cooling is performed by, for example, circulating a coolant through a liquid conduit 2, and a temperature gradient is thus formed between a temperature $T_w$ of the substrate w and a temperature $T_b$ on the metal base side. As illustrated in FIG. 2 (A), a flow of heat occurs in a direction from the substrate w to the metal base 1 side via the electrostatic chuck 6. However, if a gap d is generated between part or the whole of the substrate w and the substrate attracting surface 6a for some reason, such as a case in which partial disconnection or the like of the attraction electrode included in the electrostatic chuck has caused the attraction failure, the heat of the substrate w is not transferred to the electrostatic chuck 6 side (usually, the ion implantation or the like is processed in a vacuum, and hence there is no or extremely few substances that transfer the heat of the substrate w to the electrostatic chuck 6 side), and hence, as illustrated in FIG. 2(B), the flow of heat from the substrate w to the metal base 1 side via the electrostatic chuck 6 is stopped in the part or the whole of the substrate. By detecting such a change as a heat flux on the downstream side of the flow of heat, it is possible to determine the attached/detached state of the substrate w instantly and accurately with respect to the substrate attracting surface 6a.

As for a heat flux sensor 7 for obtaining the flow of heat transferred from the substrate w via the electrostatic chuck, it is only necessary that the heat flux sensor 7 be installed on the downstream side of the flow of heat, and also that the heat flux sensor 7 be installed in one of the electrostatic chuck 6 and the metal base 1 or in both thereof. Preferably, the heat flux sensor 7 is disposed so as to avoid such a portion that the heat flux sensor 7 interferes with the flow of heat from the substrate w. For example, the liquid conduit 2 through which a liquid coolant is caused to flow and the like are formed in the metal base 1, and if those portions are included in a path of the flow of heat from the substrate w, the heat is absorbed. This poses a fear that the attracted state of the substrate w is not determined properly. Further, taking into account the drawing of a signal wire from the heat flux sensor 7 and such other aspect, the heat flux sensor 7 is preferably disposed on the metal base side from the point of workability. More preferably, the heat flux sensor 7 is disposed so as to be flush with an upper surface of the metal base 1. There is no particular limitation on the type, the shape, etc. of the heat flux sensor 7, and thus the heat flux sensor 7 may have a thin, flat sheet-like shape or a cylindrical shape. To give a specific example, there are enumerated a series of products manufactured by Vatell Corporation, USA, including heat flux microsensors (HFM series), a sheet-like BF sensor, Thermogage, Schmidt Boelter Gage, and the like.

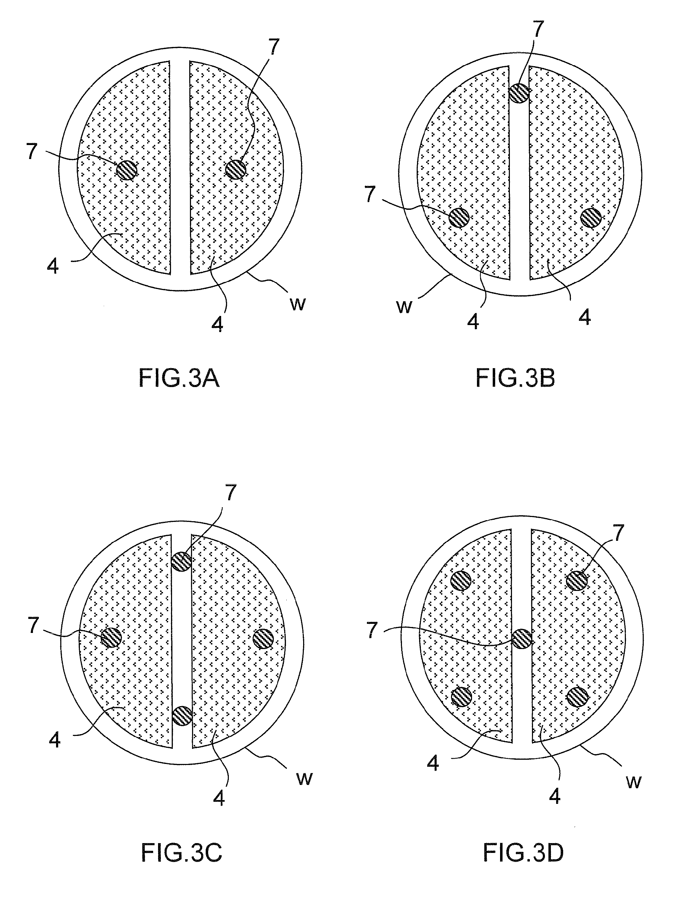

In the present invention, a plurality of the heat flux sensors 7 may be provided to obtain the heat flux at a plurality of locations with respect to a planar area of the substrate w. If the heat flux is obtained at a plurality of locations of the substrate w, the attracted state of the substrate can be recognized in more detail. For example, if the heat flux is not detected at some of the heat flux sensors 7, it is possible to determine that a gap has been generated between the substrate w and the substrate attracting surface 6a at least at positions of the substrate w which correspond to those heat flux sensors 7 due to occurrence of the attraction failure. Further, if the heat flux is not detected at all of the heat flux sensors 7, it is possible to determine that the attraction failure has occurred at positions corresponding to those heat flux sensors 7, or that lifting of the substrate w has been completed by a lifting pin or the like. Here, as causes of the failure of substrate attraction, for example, the following cases are conceivable: a case in which normal attraction cannot be performed because foreign matter, such as particles, has entered the back surface of the substrate; a case caused by unevenness of the substrate itself; and a case in which partial disconnection of the attraction electrode, partial damage of an insulating layer covering the attraction electrode, or the like has occurred in the electrostatic chuck. Further, conceivable examples of the case in which the heat flux is not detected at all of the heat flux sensors include a case in which the detachment of the substrate has been completed and a case in which the electrostatic chuck is not properly operating due to, for example, an abnormality of a power supply for supplying voltage to the attraction electrode or a failure of a voltage supply connector. Note that, FIGS. 3 illustrate examples of layout of a plurality of the heat flux sensors 7. As the number of sensors increases, it is possible to acquire a more detailed recognition of the state. However, taking into account the time and difficulty expected for the processing, an increase in cost, and such other factor, the number of sensors may be set as appropriate according to the size of the substrate w, and it is needless to say that the present invention is not limited to those examples.

Further, in the present invention, a predetermined threshold may be set for a value to be detected by the heat flux sensor 7, to thereby determine the attracted state of the substrate w. Specifically, if the heat flux measured when the electrostatic chuck device is in use falls below the threshold, as described above, it is possible to determine that a gap has been generated between the substrate w and the substrate attracting surface 6a for some reason, or that the substrate w has been released. On the other hand, as for a case in which the heat flux exceeds the threshold, conceivable factors are, for example, a case in which increased attraction voltage has increased the attraction, and a case in which water or the like has attached to the whole of the back surface of the substrate w or the substrate attracting surface 6a for some reason.

Further, in the present invention, the heat flux obtained from the heat flux sensor 7 may be used in the following manner. For example, by multiplying the heat flux ($W/m^2$) obtained from the heat flux sensor 7 by a thermal resistance per unit area ($°C \cdot m^2/W$) of a material through which the heat flux has been transferred, the temperature can be estimated. Here, the thermal resistance per unit area ($°C \cdot m^2/W$) of a material refers to "thickness of material (m) / thermal conductivity of material (W/m°C)". Accordingly, if the heat flux obtained from the heat flux sensor 7 is sampled at fixed intervals in accordance with program processing by, for example, a personal computer, and is monitored while being converted into temperature information, process monitoring of the electrostatic chuck device can be performed. In addition, based on the sampled temperature information, it is possible to acquire a real-time heat flux (that is, flux of ions) of the plasma apparatus. Further, a comparison with temperature data or the like, which is obtained separately by sampling when the attracted state of the substrate w is normal, may be performed to determine whether or not the attracted state of the substrate w is appropriate. Then, when an abnormality is confirmed, for example, a warning signal may be transmitted to a control system of a processing apparatus side that processes the substrate w, to thereby perform a display of warning, or may be used as an interlock for stopping the processing. Still further, by employing a plurality of heat flux sensors 7, the electrostatic chuck device may be provided with a self-diagnosis (failure diagnosis) function that enables estimation of causes for the attraction failure. Specifically, for example, when an abnormality has been confirmed at some of the sensors, in addition to a case in which the attraction cannot be performed properly because there exists foreign matter, such as particles, on the back surface of the substrate w, the following cases are conceivable. Those are abnormalities on the electrostatic chuck side, including partial disconnection of the attraction electrode and partial damage of an insulating layer covering the attraction electrode, which occur in the electrostatic chuck, and abnormalities on the substrate processing apparatus side, including ununiformity in ion implantation dosage. On the other hand, when an abnormality has been confirmed at all of the sensors, the following cases are conceivable. Those are abnormalities on the power supply side, which may occur in voltage value and current value supplied to the attraction electrode of the electrostatic chuck, and in voltage supply, abnormalities in the cooling water flowing through the metal base, and abnormalities on the substrate processing apparatus side, including failure in current value and energy.

Advantageous Effects of Invention

According to the electrostatic chuck device of the present invention, it is possible to determine the attracted state of the substrate quickly and accurately. In addition, the electrostatic chuck device of the present invention includes the attraction determining means therein, and hence there is no large-scale equipment or the like required, which thus provides remarkable usability from the industrial perspective. Further, according to the method of determining an attracted state of a substrate of the present invention, it is possible to determine the attachment/detachment of the substrate instantly and accurately, the attraction failure of the substrate, and the like.

Brief Description of Drawings

[FIG. 1] FIG. 1 is an explanatory sectional view of an electrostatic chuck device according to the present invention.
[FIGS. 2] FIGS. 2 are explanatory sectional views in which part of the electrostatic chuck device according to the present invention is enlarged.
[FIGS. 3] FIGS. 3 are examples of layout drawings of heat flux sensors.
[FIG. 4] FIG. 4 is an explanatory sectional view of an electrostatic chuck device provided with a failure diagnosis function.
[FIG. 5] FIG. 5 is a flow chart of failure diagnosis.

Reference Signs List

1:      metal base
1a:    mount surface
2:      liquid conduit
3:      lower insulating layer

4: attraction electrode
5: upper insulating layer
6: electrostatic chuck
6a: substrate attracting surface
7: heat flux sensor (attraction determining means)
8: amplifier
9: A/D converter
10: personal computer
w: substrate

Description of Embodiment

Hereinafter, with reference to the attached drawings, a preferred embodiment of the present invention is specifically described. Note that, the present invention is not limited to the description below.

[Manufacture of Electrostatic Chuck Device]

FIG. 1 is an explanatory sectional view of an electrostatic chuck device according to the present invention, which includes an electrostatic chuck 6 on an upper surface side of a metal base 1. The metal base 1 is made of aluminum, copper, stainless steel, or the like, and has a mount surface 1a that varies depending on the type and the size of a substrate w, such as a semiconductor substrate or a glass substrate, which is to be attracted and held. For example, the metal base 1 suitable for attraction of a silicon substrate having a diameter of 300 mm has the mount surface 1a having a diameter of approximately 298 mm. Further, the metal base 1 has a liquid channel 2 formed therein, through which a liquid coolant is caused to flow. The liquid coolant supplied from the outside is circulated via a heat exchanger (not shown) or the like in the metal base, thereby cooling the substrate w. Further, the metal base 1 may be provided with a gas supply path so that the substrate w is cooled by supplying a coolant gas such as helium, which is supplied from a lower surface side of the metal base 1, to a back surface of the substrate w through a gas supply orifice (not shown) formed in the electrostatic chuck 6. Note that, the upper surface side of the metal base 1, unless otherwise specified, refers to a side on which the substrate w is located, and the lower surface side thereof refers to a side opposite to the substrate w.

Further, the metal base 1 is provided with two heat flux sensors 7 (manufactured by Vatell Corporation, USA: HFM-7E/L) on the upper surface side thereof. The heat flux sensors 7 are each disposed such that the top of the sensor (portion from which heat flux is captured) is flush with the mount surface 1a, and, through wiring paths (not shown), signal wires or the like are drawn to the lower surface side of the metal base 1. FIG. 1 illustrates an example in which two heat flux sensors 7 are mounted. However, as illustrated in FIGS. 3, the number of sensors may be increased/decreased as appropriate depending on the shape, the size, etc. of the substrate w, and it is needless to say that other numbers, layouts, etc. than the case of FIGS. 3 may be employed for the sensors.

On the upper surface side of the metal base 1, there is formed the electrostatic chuck 6 including a lower insulating layer 3, attraction electrodes 4, and an upper insulating layer 5. As for the electrostatic chuck 6, there is no particular limitation thereon, and thus a publicly-known electrostatic chuck may be used. For example, for the lower insulating layer 3 and the upper insulating layer 5, a material having a predetermined shape and a predetermined film thickness may be used, including an insulating film made of, for example, polyimide, and a ceramic plate. Further, the lower insulating layer 3 and the upper insulating layer 5 may be formed by spraying ceramic powder, such as alumina ($Al_2O_3$) powder, aluminum nitride (AlN) powder, or zirconia ($ZrO_2$) powder. For example, in a case in which the lower insulating layer 3 and the upper insulating layer 5 are both formed of a layer sprayed with the ceramic powder, each of the layers has a film thickness of, though there is no particular limitation, approximately 20 to 300 $\mu$m. On the other hand, in a case in which the lower insulating layer 3 and the upper insulating layer 5 are formed of an insulating film made of, for example, polyimide, the film thickness thereof is generally approximately 20 to 300 $\mu$m. Note that, an upper surface side of the upper insulating layer 5 forms a substrate attracting surface 6a for attracting the substrate w, and thus may be subjected to a planarization process, such as polishing, if necessary.

As for the attraction electrode 5, apart from metal foil, a metal film formed by a sputtering method, an ion plating method, or the like may be subjected to etching into a predetermined shape, to thereby form the attraction electrode. Alternatively, the attraction electrode may be obtained by, for example, the spraying of a conductive metal or the printing of a conductive metal paste. For example, in the case of forming a metal film by the sputtering method, the ion plating method, or the like, the film thickness of the attraction electrode 5 is generally approximately 0.1 to 3 $\mu$m, whereas the film thickness of the attraction electrode 5 formed by the spraying of a conductive metal is generally approximately 10 to 50 $\mu$m. If the attraction electrode 5 has such a film thickness as described above, there occurs no particular problem in detecting the heat flux from the substrate w with the heat flux sensor provided to the mount surface 1a of the metal base 1. However, the attraction electrode 5 may be formed in such a manner that the attraction electrode 5 is not formed in a portion corresponding to a path for capturing the heat flux from the substrate w. Further, the shape of the attraction electrode 5 is not particularly limited, and thus may be set as appropriate depending on the type, the size, etc. of the substrate w to be attracted. Further, the attraction electrode 5 may constitute a so-called bipolar electrostatic chuck, in which voltage is applied to two electrodes, or may constitute a unipolar electrostatic chuck. Note that, in manufacturing the electrostatic chuck device of the present invention, the electrostatic chuck device may be formed by laminating the lower insulating layer 3, the attraction electrode 4, and the upper insulating layer 5 in the stated order on the upper surface side of the metal base 1. Alternatively, the electrostatic chuck 6 including the lower insulating layer 3, the attraction electrode 4, and the upper insulating layer 5 may be formed first and the electrostatic chuck 6 may be bonded to the upper surface side of the metal base 1 by using an adhesive or the like, to thereby obtain the electrostatic chuck device.

[Determination regarding Attracted State of Substrate]

Hereinafter, description is given of an example in which the electrostatic chuck device of the present invention illustrated in FIG. 1 was used to determine the attracted state of a silicon wafer w when ions were implanted into the silicon wafer w having a diameter of 300 mm by an ion implantation apparatus. In the electrostatic chuck device, as illustrated FIG. 3 (A), the heat flux sensors 7 (manufactured by Vatell Corporation, USA: HFM-7E/L) are mounted at two positions on the upper surface side of the metal base 1 made of aluminum and having the mount surface 1a having a diameter of 298 mm, and the heat flux sensors 7 are both disposed such that the top of the sensor is flush with the mount surface 1a. Further, on the mount surface 1a of the metal base 1, the electrostatic chuck 6 is stacked, the electrostatic chuck 6 including: the lower insulating layer 3 having a diameter of 298 mm and a film thickness of 100 $\mu$m, which is formed by spraying alumina powder having a purity of 99.99%; the attraction electrodes 4 having a film thickness of 30 $\mu$m, which are formed using a mask such that two semicircles having a diameter of 294 mm face each other with a distance between the electrodes being 2 mm; and further the upper insulating layer 5 having a diameter of 298 mm and a film thickness of 50 $\mu$m, which is formed by spraying alumina powder having a purity of 99.99%.

The above-mentioned electrostatic chuck device was set for the ion implantation apparatus (not shown), and the silicon wafer w having a diameter of 300 mm was placed on the electrostatic chuck 6. Further, voltage of 2 kV was applied between the two attraction electrodes 4, to thereby attract the silicon wafer w onto the substrate attracting surface 6a. Then, while pure water having a temperature of 20°C was caused to circulate through the liquid conduit 2 of the metal base 1 at a flow rate of 2 liters per minute, ions were implanted on the condition that the energy of the ion beam was 100 kV, the current of the ion beam was 3 mA, and the average power of the ion beam per unit area was 0.3 W/cm$^2$. During this period, the values obtained from the two heat flux sensors 7 were both 0.25 W/cm$^2$. In addition, as far as a check was conducted by a visual observation, there was no particular abnormality with the attracted state of the silicon wafer w.

After the ion implantation process was finished, the application of voltage to the attraction electrodes 4 was stopped, and further, a plasma gun was turned ON, to thereby sufficiently remove residual electric charge on the substrate attracting surface 6a of the electrostatic chuck 6. Further, when the silicon wafer w was lifted by using a push-up pin (not shown) included in the electrostatic chuck device during the ion beam irradiation, the values obtained from the two heat flux sensors 7 at the same time were both 0.01 W/cm$^2$. On this occasion, the attracted state of the silicon wafer w was actually checked by a visual observation and an infrared proximity sensor, and it was found that the silicon wafer w was in a detached state by being completely separated from the substrate attracting surface 6a. Therefore, it has been confirmed that the attracted state of the substrate can be determined by using the heat flux sensors 7 included in the electrostatic chuck device according to the present invention.

[Electrostatic Chuck Device having Failure Diagnosis Function]

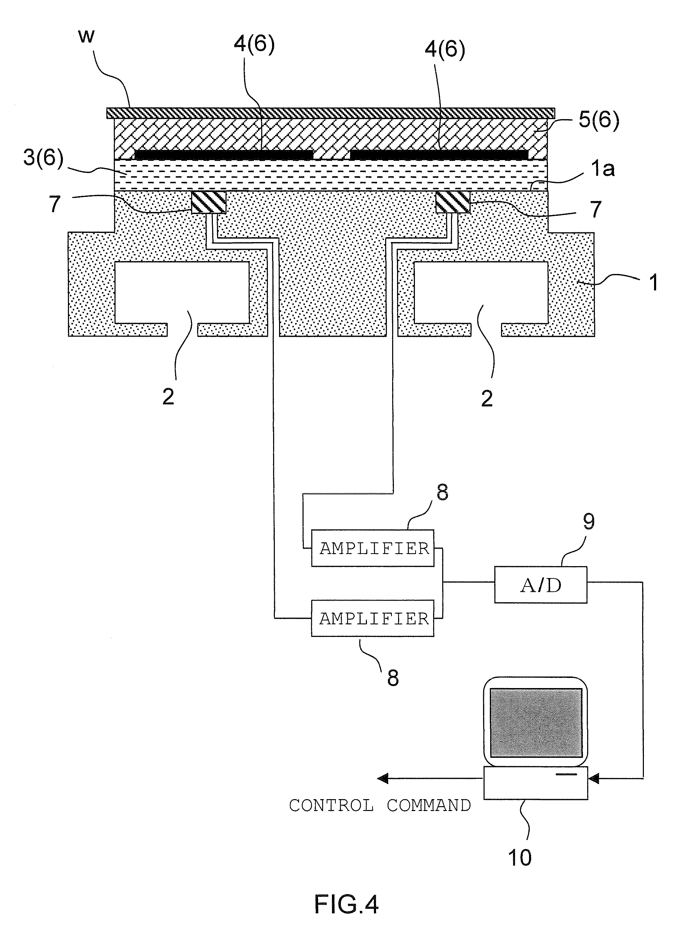

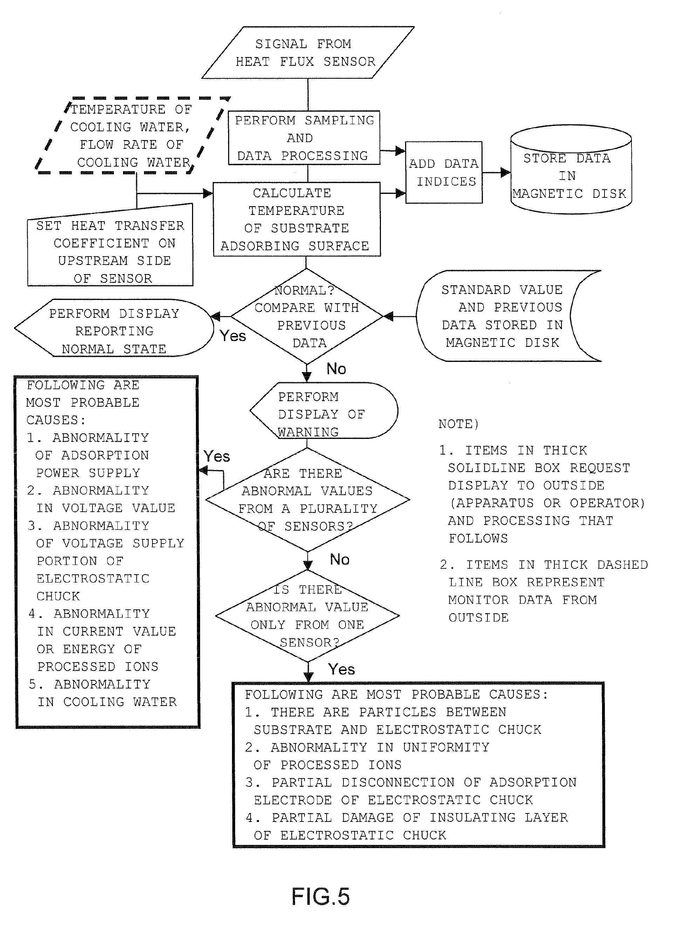

FIG. 4 illustrates an example in which the electrostatic chuck device of the present invention is provided with a failure diagnosis function. In the same manner as described above, the ion implantation apparatus was used to implant ions into the silicon wafer w having a diameter of 300 mm. During this period, signals obtained from the heat flux sensors 7 were amplified by signal amplifiers 8 to a voltage level of the order of 10 V at maximum, at which noise influences became negligible, and were then input to a personal computer 10 through an A/D (analog to digital) converter 9. An outline of processing performed on the personal computer 10 is as illustrated in a flow chart of FIG. 5. The amplified signals obtained from the heat flux sensors 7 were sampled at fixed intervals in accordance with program processing performed on the personal computer 10. A processing time required for the substrate w ranges approximately from 1 second to 1 hour depending on the details of the processing even if the same ion implantation apparatus is used, and hence the processing time may be determined by taking into account the capacity of a magnetic disk (for example, 300 GB) included in the personal computer 10. In this embodiment, a minimum sampling interval was set to 10 ms. Considering that a physical quantity to be measured is heat, which changes relatively slowly, there is no need to perform a measurement too frequently.

The sampled values are subj ected to such data processing as smoothing and noise removal before being stored in the magnetic disk. Further, the temperature and the flow rate of the cooling water flowing in the metal base 1 are monitored as well, and, based on the sampling data stored in the above-mentioned magnetic disk and the heat transfer coefficients of the lower insulating layer 3 and the upper insulating layer 5 of the electrostatic chuck 6, the temperature on the substrate attracting surface 6a of the electrostatic chuck 6 is calculated (estimated value) according to the following equation (1):

$$\text{temperature of substrate attracting surface (°C) = temperature}$$

$$\text{of cooling water (°C) + [1/average heat transfer coefficient of}$$

$$\text{cooling water (W/°C·m}^2\text{) + thermal resistance of electrostatic chuck}$$

$$\text{(°C·m}^2\text{/W)] × average incident power (W/m}^2\text{) ··· equation (1).}$$

where "temperature of cooling water (°C)" represents "the temperature of the cooling water flowing in the metal base (°C)", "heat transfer coefficient of cooling water" represents "heat transferability of water, which is the function of the temperature and the flow rate thereof", and "thermal resistance of electrostatic chuck (°C·m2/W) " represents "the sum of all thermal resistances from an upper portion of the liquid channel 2 to the back surface of the substrate w". Further, "average incident power (W/m2)" represents the heat flux, and is expressed by "the power per unit area flowing in the substrate w". For example, in the case of the ion implantation apparatus, "the average beam power of the ion beam" corresponds the average incident power, and, in the case of a plasma processing apparatus, "average incident power of ions + high-frequency power" corresponds to the average incident power.

Then, the calculated temperature is compared with, for example, previous data or a standard value obtained when there is no problem with the attracted state of the substrate w. When it is determined that there is no abnormality, a display reporting a normal state is performed, whereas when it is determined that there is an abnormality, a display of warning is performed. This warning signal may be used as an interlock for stopping the processing through transmission thereof to a control system on the ion implantation apparatus side. Further, in this embodiment, the plurality of heat flux sensors 7 are provided, and hence it is possible to perform a diagnosis by dividing causes for an attraction failure depending on the number of sensors that have detected an abnormal value. If signals obtained from a plurality of heat flux sensors show abnormal values, for example, the following are conceivable: 1) an abnormality in an attraction power supply connected to the attraction electrodes 4 of the electrostatic chuck 6; 2) an abnormality in voltage value; 3) an abnormality of a voltage supply portion of the electrostatic chuck 6; 4) an abnormality in current value or energy of processed ions; and 5) an abnormality in the cooling water (temperature rise or shortage of cooling water). In other words, such problems that are recognized in common in the electrostatic chuck device as a whole are conceivable as the causes. On the other hand, if a signal obtained from a single heat flux sensor shows an abnormal value, for example, the following local problems are conceivable as the causes: 1) existence of foreign matter such as particles between the substrate w and the electrostatic chuck 6; 2) an abnormality in uniformity of processed ions; 3) partial disconnection of the attraction electrode 4 included in the electrostatic chuck; and 4) partial damage of the upper insulating layer 5 and/or the lower insulating layer 3 included in the electrostatic chuck.

Industrial Applicability

The electrostatic chuck device of the present invention is applicable as various electrostatic chuck devices used in, for example, a semiconductor manufacturing process or a liquid crystal manufacturing process, and enables determining the attracted state of a processing-target substrate accurately and instantly, such as a semiconductor substrate or a glass substrate. In particular, according to the method of determining an attracted state of a substrate, which employs the heat flux sensor, it is possible to quickly determine the attached/detached state of the substrate with respect to the substrate attracting surface based on a change in heat flux. Therefore, the present invention is remarkably effective in a case in which, for example, continuous processing is required, such as the semiconductor manufacturing process.

**Claims**

1. An electrostatic chuck device, comprising:

    an electrostatic chuck for attracting a substrate, the electrostatic chuck being provided on an upper surface side of a metal base; and
    attraction determining means for determining an attracted state of the substrate.

2. An electrostatic chuck device according to claim 1, wherein the attraction determining means comprises a heat flux sensor, and determine the attracted state of the substrate based on a flow of heat transferred from the substrate via the electrostatic chuck.

3. An electrostatic chuck device according to claim 2, wherein the heat flux sensor is disposed on a metal base side.

4. An electrostatic chuck device according to claim 3, wherein the heat flux sensor is disposed so as to be flush with an upper surface of the metal base.

5. An electrostatic chuck device according to any one of claims 2 to 4, wherein a heat flux is obtained at a plurality of locations with respect to a planar area of the substrate.

6. A method of determining an attracted state of a substrate, which is used for an electrostatic chuck device comprising an electrostatic chuck for attracting the substrate, the electrostatic chuck being provided on an upper surface side of a metal base,
    the method comprising obtaining, by a heat flux sensor, a flow of heat transferred from the substrate via the electrostatic chuck, to thereby determine the attracted state of the substrate.

7. A method of determining an attracted state of a substrate according to claim 6, wherein the heat flux sensor is disposed on a metal base side.

8. A method of determining an attracted state of a substrate according to claim 7, wherein the heat flux sensor is disposed so as to be flush with an upper surface of the metal base.

9. A method of determining an attracted state of a substrate according to any one of claims 6 to 8, wherein a heat flux is obtained at a plurality of locations with respect to a planar area of the substrate.

FIG.1

**FIG.2A**

**FIG.2B**

FIG.3A

FIG.3B

FIG.3C

FIG.3D

FIG.4

SIGNAL FROM
HEAT FLUX SENSOR

TEMPERATURE OF
COOLING WATER,
FLOW RATE OF
COOLING WATER

PERFORM SAMPLING
AND
DATA PROCESSING

ADD DATA
INDICES

STORE DATA
IN
MAGNETIC DISK

SET HEAT TRANSFER
COEFFICIENT ON
UPSTREAM SIDE
OF SENSOR

CALCULATE
TEMPERATURE
OF SUBSTRATE
ADSORBING SURFACE

NORMAL?
COMPARE WITH
PREVIOUS
DATA

STANDARD VALUE
AND PREVIOUS
DATA STORED IN
MAGNETIC DISK

PERFORM DISPLAY
REPORTING
NORMAL STATE

Yes

No

FOLLOWING ARE
MOST PROBABLE
CAUSES:
1. ABNORMALITY
OF ADSORPTION
POWER SUPPLY
2. ABNORMALITY
IN VOLTAGE VALUE
3. ABNORMALITY
OF VOLTAGE SUPPLY
PORTION OF
ELECTROSTATIC
CHUCK
4. ABNORMALITY
IN CURRENT VALUE
OR ENERGY OF
PROCESSED IONS
5. ABNORMALITY
IN COOLING WATER

PERFORM
DISPLAY OF
WARNING

Yes

ARE THERE
ABNORMAL VALUES
FROM A PLURALITY
OF SENSORS?

No

IS THERE
ABNORMAL VALUE
ONLY FROM ONE
SENSOR?

Yes

NOTE)

1. ITEMS IN THICK
SOLIDLINE BOX REQUEST
DISPLAY TO OUTSIDE
(APPARATUS OR OPERATOR)
AND PROCESSING THAT
FOLLOWS

2. ITEMS IN THICK DASHED
LINE BOX REPRESENT
MONITOR DATA FROM
OUTSIDE

FOLLOWING ARE MOST PROBABLE CAUSES:
1. THERE ARE PARTICLES BETWEEN
SUBSTRATE AND ELECTROSTATIC CHUCK
2. ABNORMALITY IN UNIFORMITY
OF PROCESSED IONS
3. PARTIAL DISCONNECTION OF ADSORPTION
ELECTRODE OF ELECTROSTATIC CHUCK
4. PARTIAL DAMAGE OF INSULATING LAYER
OF ELECTROSTATIC CHUCK

FIG.5

## INTERNATIONAL SEARCH REPORT

| International application No. |
|---|
| PCT/JP2009/064831 |

A.   CLASSIFICATION OF SUBJECT MATTER
H01L21/683(2006.01)i, H02N13/00(2006.01)i, B23Q3/15(2006.01)n

According to International Patent Classification (IPC) or to both national classification and IPC

B.   FIELDS SEARCHED

Minimum documentation searched (classification system followed by classification symbols)
H01L21/67-21/687, H02N13/00, B23Q3/15

Documentation searched other than minimum documentation to the extent that such documents are included in the fields searched
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C.   DOCUMENTS CONSIDERED TO BE RELEVANT

| Category* | Citation of document, with indication, where appropriate, of the relevant passages | Relevant to claim No. |
|---|---|---|
| X<br>A | JP 2002-222850 A  (Mitsubishi Electric Corp.),<br>09 August 2002 (09.08.2002),<br>paragraph [0035]; fig. 1<br>(Family: none) | 1<br>2-9 |
| X<br>A | JP 2004-047512 A  (Tokyo Electron Ltd.),<br>12 February 2004 (12.02.2004),<br>paragraphs [0037] to [0124]; fig. 1 to 10<br>(Family: none) | 1<br>2-9 |
| X<br>A | JP 2000-228440 A  (Nissin Electric Co., Ltd.),<br>15 August 2000 (15.08.2000),<br>abstract; fig. 1<br>(Family: none) | 1<br>2-9 |

[X]   Further documents are listed in the continuation of Box C.      [ ]   See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered  to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>15 October, 2009 (15.10.09) | Date of mailing of the international search report<br>27 October, 2009 (27.10.09) |
|---|---|
| Name and mailing address of the ISA/<br>Japanese Patent Office | Authorized officer |
| Facsimile No. | Telephone No. |

Form PCT/ISA/210 (second sheet) (April 2007)

15

**INTERNATIONAL SEARCH REPORT**

| International application No. |
|---|
| PCT/JP2009/064831 |

C (Continuation).   DOCUMENTS CONSIDERED TO BE RELEVANT

| Category* | Citation of document, with indication, where appropriate, of the relevant passages | Relevant to claim No. |
|---|---|---|
| Y<br>A | JP 2006-202939 A  (Mitsubishi Heavy Industries, Ltd.),<br>03 August 2006 (03.08.2006),<br>paragraphs [0066] to [0077]<br>(Family: none) | 1<br>2-9 |
| Y<br>A | JP 11-330220 A  (ULVAC Japan Ltd.),<br>30 November 1999 (30.11.1999),<br>abstract; paragraph [0060]<br>(Family: none) | 1<br>2-9 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 7007074 A
- JP 2000228440 A
- JP 10150099 A
- JP 2004047512 A